(19) Europäisches Patentamt
European Patent Office
Office européen des brevets

(11) Veröffentlichungsnummer: **0 009 558**
**B1**

(12) **EUROPÄISCHE PATENTSCHRIFT**

(45) Veröffentlichungstag der Patentschrift: **07.04.82**

(51) Int. Cl.³: **H 01 L 21/302,**
H 01 L 21/20, C 23 C 15/00

(21) Anmeldenummer: **79102644.6**

(22) Anmeldetag: **25.07.79**

# (54) Verfahren und Vorrichtung zur Modifizierung einer Oberfläche mittels Plasma.

(30) Priorität: **21.08.78 US 934733**

(43) Veröffentlichungstag der Anmeldung:
**16.04.80 Patentblatt 80/8**

(45) Bekanntmachung des Hinweises auf die Patenterteilung:
**07.04.82 Patentblatt 82/14**

(84) Benannte Vertragsstaaten:
**DE FR GB**

(56) Entgegenhaltungen:
**DD - A - 63 253**
**DE - A1 - 2 340 442**
**DE - A1 - 2 716 592**
**DE - A1 - 2 727 788**
**DE - A1 - 2 810 554**
**FR - A1 - 2 308 200**
**GB - A - 1 417 085**
**GB - A - 1 498 459**
**GB - A - 1 513 218**
**US - A - 3 536 547**

(73) Patentinhaber: **International Business Machines Corporation**
**Armonk, N.Y. 10504 (US)**

(72) Erfinder: **Mc Kenna, Charles Michael**
**7 Wedgewood Road**
**Fishkill, New York 12524 (US)**
Erfinder: **Willcox, Henry Keith**
**Clover Hill**
**Poughkeepsie, New York 12603 (US)**

(74) Vertreter: **Kreidler, Eva-Maria, Dr. rer. nat.**
**Schönaicher Strasse 220**
**D-7030 Böblingen (DE)**

(56) References cited:
**"Lexikon Technik und exakte Naturwissenschaften" Band 8: "Photoeffekt-Sandpapier" November 1972, FISCHER TASCHENBUCH VERLAG, Frankfurt am Main, S. 2259—2260**

**EP 0 009 558 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Verfahren und Vorrichtung zur Modifizierung einer Oberfläche mittels Plasma

Die Erfindung betrifft ein Verfahren zur Modifizierung einer Oberfläche durch Ätzen oder Abscheiden einer Schicht auf derselben, bei dem ein Plasma eines reaktiven Gases erzeugt wird. Die Erfindung betrifft auch eine Vorrichtung zur Durchführung dieses Verfahrens.

Bei der Herstellung von Halbleiterbauelementen werden Ätzverfahren angewendet, um Bereiche auf dem Siliciumsubstrat für die Diffusion oder Ionenimplantation von Verunreinigungen zur Herstellung integrierter Schaltkreise in dem Siliciumsubstrat freizulegen. Ein Ätzverfahren ist beispielsweise das Plasmaätzen oder das reaktive Ionenätzen. Bei diesem Verfahren wird ein chemisch reaktives Gas, wie $CF_4$ angewendet. Die Oberfläche des zu ätzenden Substratmaterials wird mit einer Maske bedeckt, welche die gewünschten Bereiche der Oberfläche freilegt. Das Substratmaterial mit der zu ätzenden Oberfläche wird in eine Kammer, welche ein reaktives Gas enthält, eingebracht. Zur Erzeugung des Plasmas wird eine Hochfrequenz-Wechselspannung an das Gas angelegt, welche bewirkt, daß das Gas unter Ausbildung verschiedener Bestandteile dissoziiert, beispielsweise unter Bildung positiver und negativer Ionen, von Atomen wie Fluor und Radikalen. Das Plasma reagiert mit der Oberfläche und bildet flüchtige Produkte unter Erhalt einer geätzten Oberfläche in den freigelegten Bereichen.

Aus der US—A—1 513 218 ist beispielsweise ein Verfahren zur Modifizierung einer Oberfläche durch Ätzen bekannt, bei dem ein Plasma eines reaktiven Gases erzeugt wird, das aus einer in Fluoratome dissoziierenden Verbindung und Sauerstoff besteht. Weiterhin ist aus dem Lexikon "Technik und exakte Naturwissenschaften", Band 8, November 1972, Fischer Taschenbuch Verlag, Seite 2260 bekannt, ein Gas zur Fotoionisation einer Strahlung auszusetzen.

Indem man das Gas und die Bedingungen ändert, kann das Plasma in bekannter Weise auch benutzt werden, um anstelle einer Ätzung der Oberfläche eine Schicht auf dem Substrat abzuscheiden. Die Plasmaätz- oder Abscheidungsraten sind von der Hochfrequenzspannung und Frequenz, den Gasdrucken und Zusammensetzungen, der Temperatur, der Substratvorspannung und der Gasflußdynamik abhängig. Die Änderung eines der oben genannten Parameter gestattet jedoch nicht, die Plasmaätz- oder Abscheidungsrate zeitlich genau zu kontrollieren. Eine Kontrolle dieser Art ist erwünscht, beispielsweise wenn beim Plasmaätzen eine Zwischenschicht aus kritischem Material erreicht wird und die Ätzrate herabgesetzt werden soll.

Hochreaktive Bestandteile, wie Halogen oder Sauerstoff, vorzugsweise in atomarem Zustand, entweder neutral oder ionisiert, sind beim Plasmaätzen erwünscht. Es wird angenommen, daß das atomare Fluor in dem Plasma, welches aus einem Gas von $CF_4$ mit einem kleinen Prozentgehalt von Sauerstoff erzeugt wurde, mit dem Silicium und den Oxiden und Nitriden des Siliciums nach den folgenden Reaktionsgleichungen reagiert:

$$CF_4 \rightarrow C + 4F \xrightarrow{O_2} CO_2 + 4F$$

$$4F + Si \rightarrow SiF_4$$

$$4F + SiO_2 \rightarrow SiF_4 + O_2$$

$$12F + Si_3N_4 \rightarrow 3SiF_4 + 2N_2$$

Das Ätzen oder Veraschen von organischem Material, wie Photoresist wird vorzugsweise mit atomarem Sauerstoff durchgeführt. Eine allgemeine Reaktionsgleichung sieht folgendermaßen aus:

$$C_xH_y + 3O \rightarrow CO_2 + H_2O$$

Weil Luft, wie auch Glas, Quarz und kristalline Fenstermaterialien unter Wellenlängen von etwa 200 nm undurchlässig sind und demzufolge in einem Vakuum gearbeitet werden muß, wird dieser Bereich des elektromagnetischen Spektrums im allgemeinen mit Vakuumultraviolett bezeichnet. Dieser Wellenlängenbereich entspricht einem Photonen-Energiebereich von 60 KeV bis 6 eV. Die Ionisationspotentiale der meisten organischen Verbindungen, wie $CF_4$ liegen im Bereich von 8 bis 13 eV, so daß organische Moleküle, welche im Wellenlängenbereich des Vakuumultravioletts absorbieren, auch Ionen ausbilden.

Aufgabe der Erfindung ist ein Verfahren und eine Vorrichtung zur zeitlichen Kontrolle eines Plasmaätz- oder Abscheidungsverfahrens. Aufgabe der Erfindung ist auch eine Kontrolle der Dissoziation des Gases zur Ausbildung des Plasmas, vorzugsweise der Dissoziation stabiler organischer Halogenverbindungen und molekularen Sauerstoffs und Fluor. Weiterhin soll mit dem erfindungsgemäßen Verfahren und der Vorrichtung die Wahl bestimmter Bestandteile für die Dissoziation möglich sein, und das erfindungsgemäße Verfahren soll eine Kontrolle des Plasmaätzens oder der Abscheidung nur in bestimmten Bereichen der Substratoberfläche gestatten.

Die Aufgabe der Erfindung wird gelöst durch ein Verfahren der eingangs genannten Art, das dadurch gekennzeichnet ist, daß das Gas einer Vakuumultraviolett-Bestrahlung ausgesetzt wird, deren Energie und Intensität so gewählt sind, daß das Gas in die Modifizierung der Oberfläche bewirkende Komponenten dissoziiert und

über die Steuerung der Dissoziation eine Kontrolle der Oberflächenmodifizierung möglich ist.

Vorteilhafte Ausgestaltungen der Erfindung sind in den Unteransprüchen niedergelegt.

Die durch die Erfindung erreichten Vorteile sind im wesentlichen darin zu sehen, daß eine genaue zeitliche Kontrolle der Oberflächenmodifizierung der Halbleitersubstratmaterialien möglich ist. Durch die Wahl einer bestimmten Plasmazusammensetzung kann das erfindungsgemäße Verfahren entweder zum Ätzen oder zur Abscheidung von Materialien in bestimmten Bereichen der Substratoberfläche eingesetzt werden.

Im folgenden wird die Erfindung anhand der speziellen Beschreibung und der Figuren 1 bis 3 näher erläutert.

Es zeigen:

Fig. 1 einen schematischen Querschnitt einer Vorrichtung zur Erzeugung von Strahlung im Vakuumultraviolett-Bereich in Verbindung mit einem Plasmareaktor.

Fig. 2 einen schematischen Querschnitt einer anderen Anordnung dieser Art.

Fig. 3 einen schematischen Querschnitt einer weiteren Anordnung dieser Art.

Um die zuvor genannten Vorteile der Erfindung zu erreichen, wird ein Plasmareaktor mit einer Strahlenquelle, die bestimmte Wellenlängen des Vakuumultraviolett-Bereichs emittiert, angewendet, und diese Strahlung wird auf die Bestandteile des Plasmas, vorzugsweise in unmittelbarer Nachbarschaft des Substrats gerichtet, um einen Wechsel, wenigstens in bestimmten Bereichen der Substratoberfläche, zu erhalten, wodurch eine Kontrolle des Plasmaverfahrens, insbesondere an der Substratoberfläche, möglich ist. Im einzelnen sind die bevorzugten Bestandteile des Plasma für das reaktive Ionenätzen $O_2$, $F_2$ und stabile organische Halogenverbindungen wie $CF_4$, für deren Photoionisation und Dissoziation Wellenlängen im Spektralbereich des Vakuumultravioletts erforderlich sind. Plasmabestandteile, die eine Abscheidung bewirken, erfordern auch Wellenlängen im Vakuumultraviolett-Bereichs des elektromagnetischen Spektrums.

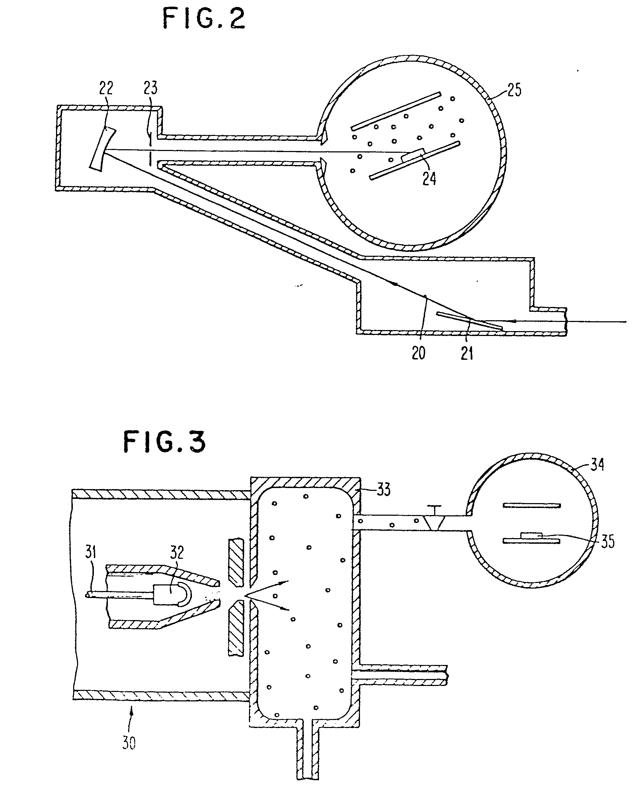

Wie in Fig. 1 gezeigt ist, ist die Vorrichtung, die in einer Vakuumkammer 1 eingeschlossen ist, eine Funkenentladungsquelle 2 mit wiederholten Entladungen zur Erzeugung von Vakuumultraviolett-Strahlung mit einem Wellenlängenkontinuum im Bereich von 60 bis 100 nm. Die Quelle 2 liegt an einer Spannungsquelle 3, und die Funkenstrecke 4 bricht ab, wenn die Spannung am Kondensator 5 hinreichend groß ist. Die Zeit, die erforderlich ist, um den Kondensator aufzuladen, wird bestimmt durch die Zeitkonstante des Kondensators 5 und den Widerstand 6, deren Produkt die Wiederholungsrate bestimmt. Wenn es gewünscht wird, kann die Funkenstrecke 4 durch einen Thyratron-Schaltkreis ersetzt werden. Die Quelle 2 ist von gereinigtem Helium umgeben, das während des Abbrechens der Funkenstrecke 4 ein kontinuierliches Spektrum von 60 bis 100 nm emittiert. Zur Erzeugung von Vakuumultraviolett-Strahlung ist ein Duoplasmatron, welches in Fig. 3 dargestellt ist, noch besser geeignet. Es kann anstelle der zuvor genannten Strahlungsquelle 2 eingesetzt werden. Das Vakuumultraviolett-Kontinuum passiert den Eingangspalt 9 eines Monochromators und wird durch ein konkaves Gitter 10 durch den Ausgangsspalt 7 in den Plasmareaktor 8 reflektiert und fokussiert, und die Strahlung wird durch die Bestandteile des Plasmas in der Umbebung der zu behandelnden Vorrichtung absorbiert, welche in vorliegenden Fall ein Siliciumwafer mit einer Siliciumdioxidschicht ist, die selektiv geätzt werden soll. Eine typische Intensität am Ausgangsspalt 7 eines Monochromators mit einem Bandpaß von 0,05 nm ist in der Größenordnung von $10^8$ Photonen/Sek. Der Ausgangsspalt 7, der Eingangsspalt 9 und das Gitter 10 sind auf einem Kreis 11, der durch gestrichelte Linien angedeutet ist und als Rowland-Kreis bezeichnet wird, angeordnet. Durch Rotation dieser optischen Bestandteile 7, 9 und 10 des Monochromators entlang des Rowland-Kreises können verschiedene Wellenlängen aus dem Kontinuierlichen Spektrum ausgewählt werden, die den Absorptionswellenlängen der Plasmabestandteile, im vorliegenden Fall von $CF_4$, entsprechen und deren Absorption eine Dissoziation bewirkt under Erhalt von Fluoratomen zum Ätzen des Siliciumdioxids. Weil die Vakuumultraviolett-Strahlenquelle während des Plasmaätzens (oder während der Abscheidung) jederzeit an- oder abgestellt werden kann, kann das Ätzen zeitlich genau verfolgt werden.

Wenn man von der Modifizierung des Ausgangsspaltes 7 in der Wand des Plasmareaktors 8 absieht, kann der Reaktor ein beliebiger der im Handel erhältlichen Reaktoren sein, oder es kann ein Reaktor, der in der europäischen Patentanmeldung 78 106 659.7 beschrieben ist, angewendet werden. Der Träger 12 des Reaktors 8 sollte jedoch beweglich, im vorliegenden Fall drehbar sein, wie durch den Pfeil 13 angedeutet ist, damit verschiedene Bereiche der zu ätzenden Vorrichtung und verschiedene Vorrichtungen unter dem Vakuumultraviolett-Strahl angeordnet werden können. Auf diese Weise können ausgewählte Bereiche der Vorrichtung mit verschiedenen Geschwindigkeiten geätzt werden. Die Abscheidungsrate auf ausgewählten Bereichen der Vorrichtung kann auch durch Bestrahlung diese Bereiche variiert werden. Weitere Angaben bezüglich der Funkenentladungsquelle des Vakuumultraviolett-Bereichs und des Monochromators können in "Techniques of Vacuum Ultraviolet Spectroscopy", von James A. R. Samson, John Wiley & Sons (1967) gefunden werden.

In einem Ausführungsbeispiel wird die zu ätzende Vorrichtung 14 (oder die Vorrichtung,

auf die eine Schicht aufgebracht werden soll) in den Plasmareaktor 8 in die übliche $CF_4 + O_2$-Umgebung gegeben. Während des konventionellen Ätzens wird der Vakuumultraviolett-Strahl erzeugt, um die Ätzrate bereits von Anfang an auf ein Maximum zu bringen, indem für die Ätzung zusätzlich Fluoratome durch die Dissoziation der $CF_4$-Moleküle erzeugt werden und Sauerstoffatome durch Dissoziation aus $O_2$-Molekülen, die mit Kohlenstoff unter Ausbildung von gasförmigem $CO_2$ reagieren. Die Bestrahlung wird abgestellt, wenn das Ätzen seinen Endpunkt erreicht, um so die Ätzrate zu verlangsamen. Natürlich kann der Strahl jederzeit zu- oder abgeschaltet werden, um das Ätzprofil zu verändern oder aus irgendeinem anderen Grund, welcher eine zeitlich genaue Kontrolle der Ätzrate erforderlich macht. Das gleiche trifft für den Abscheidungsprozeß zu.

In dem Ätzprozeß wird vorzugsweise ein Substratmaterial eingesetzt, dessen Komponenten alle zur Ausbildung flüchtiger Substanzen unter den Ätzbedingungen fähig sind. Außerdem sollte das Ätzmittel ein Material sein, dessen Ätzcharakteristik durch die Anwendung von Strahlung unter den üblichen Drucken oder Temperaturen aktiviert oder erheblich gesteigert wird. Dafür ist normalerweise ein Absorptionsspektrum des Materials erforderlich, welches eine Wellenlänge oder Wellenlängen des Vakuumultraviolett-Spektralbereichs umfaßt, so daß eine Dissoziation während des Ätzens stattfindet. Gleiches gilt für die Abscheidung. Die Spektren der gewünschten Ätzmittel sind enthalten in "Some Aspects of Vacuum Ultraviolet Radiation Physics", von B. Vodar und J. Romand, Pergamon Press (1974) und in "Chemical Spectroscopy and Photochemistry in the Vacuum-Ultraviolet", Von Sandorfy, Ausloos und Robin, D. Reidel Publishing Co. (1974).

Als bevorzugtes Ätzmittel gemäß der vorliegenden Erfindung wird $CF_4$ eingesetzt. Es kann jedoch auch $F_2$ als Ätzmittel oder als Quelle für Fluoratome verwendet werden. Zur Veraschung von Photoresist ist $O_2$ das bevorzugte Ätzmittel.

Natürlich wird das Verfahren unter Vakuum, d.h., normaler weise bei Drucken von $6.610^{-3}$ mbar ($5 \times 10^{-3}$ Torr) bis etwa $6.610^{-1}$ mbat ($5 \times 10^{-1}$ Torr) durchgeführt. Die unterste Grenze für die Fließgeschwindigkeit des Ätzmittels wird im allgemeinen durch die gewünschte Ätzrate bestimmt. Die oberste Grenze wird primär durch die Kapazität des Pumpsystems bestimmt. Raumtemperatur (etwa 300°K) wird für das Verfahren der vorliegenden Erfindung bevorzugt; wenn es gewünscht wird, können jedoch auch höhere Temperaturen angewendet werden.

Anstelle der Funkenentladungsquelle von Fig. 1 kann alternativ auch ein Synchroton zur Erzeugung der Vakuumultraviolett-Strahlung (Strahl 20 in Fig. 2) angewendet werden. Es kann beispielsweise ein 180 MeV Synchroton, welches in Journal of Applied Physics, 36, 380 (1965) beschrieben ist, angewendet werden, welches in intensives Strahlungskontinuum im gesamten Vakuumultraviolett-Spektralbereich emittiert. Weitere Angaben über diese Synchroton und andere können in der genannten Literaturstelle und in "Techniques of Vacuum Ultraviolet Spectroscopy" und den dort angegebenen Literaturzitaten und in "Chemical Spectroscopy and Photochemistry in the Vacuum Ultraviolet" gefunden werden. Wie in Fig. 2 gezeigt ist, wird der Strahl 20 des Synchrotons von einem ersten Spiegel 21 reflektiert, ehe er auf ein Gitter 22 des Monochromators trifft und durch den Ausgangsspalt 23 auf die in dem Plasmareaktor 25 zu ätzende Vorrichtung 24 reflektiert wird.

Eine weitere alternative Vorrichtung wird in Fig. 3 gezeigt, in der die Gasmoleküle des Ätzmittels der Vakuumultraviolett-Strahlung ausgesetzt werden, um auch diese in reaktive Bestandteile zu dissoziieren, ehe sie in den Plasmareaktor eingeführt werden. In diesem Ausführungsbeispiel ist die Vakuumultraviolett-Strahlungsquelle ein Duoplasmatron 30 (teilweise gezeigt), welches ein Linienspektrum emittiert in Abhängigkeit von dem Gas, welches durch den Einlaß 31 eingeführt und in der Umgebung des Fadens 32 vorhanden ist. Das Gas wird wegen seiner Emissionslinien ausgewählt, die den Absorptionsspektren oder der Dissoziationsenergie der Gasmoleküle in der Kammer 33, welche als Plasmaätzmittel verwendet werden, entsprechen. Wenn auch in der Abbildung nicht gezeigt, ist es erwünscht, einen Monochromator wie in Fig. 1 zu verwenden, weil das Duoplasmatron auch ein Wellenlängenkontinuum emittiert und es erforderlich sein kann, die Emission auf die Dissoziationsenergie der Gasmoleküle einzustellen. Nachdem das ätzende Gas der Vakuumultraviolett-Strahlung ausgesetzt war, enthält es nunmehr reaktive Bestandteile wie Fluoratome und wird in den Plasmareaktor 34 geleitet. Durch die Anwesenheit der reaktiven Bestandteile wird die Ätzrate beeinflußt, so daß durch die Kontrolle der sich bildenden reaktiven Bestandteile in der Kammer 33 das Ätzen der Vorrichtung 35 in dem Reaktor 34 kontrolliert werden kann. Weitere Angaben über das Duoplasmatron können in "Techniques of Vacuum Ultraviolet Spectroscopy" gefunden werden.

Aus den vorherigen Ausführungen ist ersichtlich, daß mit der vorliegenden Erfindung bestimmte Bestandteile des Plasmas, die dissoziieren, ausgewählt werden können, indem der Monochromator auf die Dissoziationsenergie derselben eingestellt wird.

**Patentansprüche**

1. Verfahren zur Modifizierung einer Oberfläche durch Ätzen oder Abscheiden einer Schicht auf derselben, bei dem ein Plasma eines reaktiven Gases erzeugt wird, dadurch gekennzeichnet, daß das Gas einer Vakuumultraviolett-Strahlung ausgesetzt wird, deren Energie und Intensität so gewählt sind, daß das Gas in die Modifizierung der Oberfläche bewirkende Komponenten dissoziiert und über die Steuerung der Dissoziation eine Kontrolle der Oberflächenmodifizierung möglich ist.

2. Verfahren nach Anspruch 1, dadurch gekennzeichnet, daß ein reaktives Gas mit einem Gehalt einer in Fluoratome dissoziierenden Verbindung und ggf. Sauerstoff angewendet wird.

3. Verfahren nach den Ansprüchen 1 oder 2, dadurch gekennzeichnet, daß das Gas, ehe es in ein Plasma umgewandelt wird, bestrahlt wird.

4. Verfahren nach den Ansprüchen 1 oder 2, dadurch gekennzeichnet, daß das Gas als Plasma vorliegt und in der Umgebung der zu modifizierenden Oberfläche bestrahlt wird.

5. Verfahren nach den Ansprüchen 3 oder 4, dadurch gekennzeichnet, daß das Gas in der Umgebung ausgewählter Teile der Oberfläche bestrahlt wird, damit die bestrahlten und die nicht bestrahlten Teile derselben in unterschiedlicher Weise modifiziert werden.

6. Verfahren nach einem oder mehreren der Ansprüche 1 bis 5, dadurch gekennzeichnet, daß die Modifizierung der Oberfläche durch Ätzen erfolgt.

7. Verfahren nach einem oder mehreren der Ansprüche 1 bis 6, dadurch gekennzeichnet, daß die Oberfläche einer Siliciumdioxodschicht, die auf einer Siliciumhalbleitervorrichtung angeordnet ist durch Ätzen modifiziert wird.

8. Verfahren nach einem oder mehreren der Ansprüche 1 bis 7, dadurch gekennzeichnet, daß ein Gas mit einem Gehalt an verschiedenen Molekülen und/oder Radikalen angewendet wird und die Energie der Vakuumultraviolett-Strahlung auf die Dissoziationsenergie wenigstens eines der Moleküle und/oder Radikale eingestellt wird.

9. Vorrichtung zur Durchführung der Verfahrens gemäß den Patentansprüchen 1 bis 8, gekennzeichnet durch eine Strahlungsquelle (2, 30) zur Erzeugung von Vakuumultraviolett-Strahlung, einen Monochromator (7, 9, 10) zur Selektierung von Strahlung mit bestimmter Energie, einen Plasmareaktor (8, 34) mit einer Gasvorratskammer und einer Anordnung, mit der die Strahlung, deren Energie mit der Dissoziationsenergie des Gases überlappt, wenigstens auf einen Teil des Gases gerichtet wird.

**Claims**

1. Method for modifying a surface by etching, or by depositing a layer thereon, wherein a plasma of reactive gas is generated, characterized in that the gas is exposed to a vacuum ultraviolet radiation whose energy and intensity are such that the gas is disassociated in two components effecting the surface modification, and that via the control of the disassociation the surface modification can be controlled.

2. Method as claimed in claim 1, characterized in that a reactive gas with a compound disassociating into fluorine, and if possible oxygen is used.

3. Method as claimed in claims 1 or 2, characterized in that prior to being converted into a plasma the gas is irradiated.

4. Method as claimed in claims 1 or 2, characterized in that the gas exists as a plasma, and is irradiated adjacent to the surface to be modified.

5. Method as claimed in claims 3 or 4, characterized in that the gas is irradiated adjacent to selected parts of the surface, so that the irradiated and the non-irradiated parts thereof are modified differently.

6. Method as claimed in any one or several of claims 1 to 5, characterized in that the modification of the surface is effected by means of etching.

7. Method as claimed in any one or several of claims 1 to 6, characterized in that the surface of a silicon dioxide layer arranged on a silicon semiconductor device is modified by means of etching.

8. Method as claimed in any one or several of claims 1 to 7, characterized in that a gas containing different molecules and/or radicals is used, and that the energy of the vacuum ultraviolet radiation is adjusted to the disassociation energy of at least one of the molecules and/or radicals.

9. Device for carrying out the method according to patent claims 1 to 8, characterized by a radiation source (2, 30) to generate vacuum ultraviolet radiation, a monochromator (7, 9, 10) for selecting a radiation with a predetermined energy, a plasma reactor (8, 34) with a gas storage chamber, and with an arrangement with which the radiation whose energy overlaps with the disassociation energy of the gas, is directed onto at least part of the gas.

**Revendications**

1. Procédé pour modifier une surface par décapage ou par dépôt d'une couche sur celle-ci, dans lequel on produit un plasma d'un gaz réactif, caractérisé en ce que le gaz est soumis à un rayonnement ultraviolet sous vide, dont l'énergie et l'intensité sont choisies de telle sorte que le gaz se dissocie en composantes provoquant la modification de la surface et que la commande de la dissociation permet un contrôle de la modification de la surface.

2. Procédé selon la revendication 1, caractérisé en ce qu'on utilise un gaz réactif contenant une composition se dissociant en atomes de fluore et le cas échéant de l'oxygène.

3. Procédé selon la revendication 1 ou 2, caractérisé en ce que le gaz est irradié avant d'être transformé en plasma.

4. Procédé selon la revendication 1 ou 2, caractérisé en ce que le gaz est présent sous forme de plasma et est irradié au voisinage de la

surface à modifier.

5. Procédé selon la revendication 3 ou 4, caractérisé en ce que le gaz est irradié au voisinage de parties sélectionnées de la surface afin de modifier les parties irradiées et non irradiées de cette surface d'une manière différente.

6. Procédé selon l'une quelconque ou plusieurs des revendications 1 à 5, caractérisé en ce que la modification de la surface est effectuée par un décapage.

7. Procédé selon l'une quelconque ou plusieurs des revendications 1 à 6, caractérisé en ce que la surface d'une couche de dioxyde de silicium disposée sur un dispositif semiconducteur de silicium est modifiée par décapage.

8. Procédé selon l'une quelconque ou plusieurs des revendications 1 à 7, caractérisé en ce qu'on utilise un gaz ayant un contenu de différentes molécules et/ou radicaux et que l'énergie du rayonnement ultraviolet sous vide est ajustée à l'énergie de dissociation d'au moins l'un des molécules et/ou radicaux.

9. Dispositif pour exécuter le procédé selon les revendications 1 à 8, caractérisé par une source de rayonnement (2, 30) pour produire un rayonnement ultraviolet sousvide, un monochromateur (7, 9, 10) pour sélectionner un rayonnement d'une énergie donnée, un réacteur à plasma (8, 34) muni d'une chambre de stockage de gaz, et un arrangement à l'aide duquel le rayonnement dont l'énergie recouvre l'énergie de dissociation du gaz est dirigé sur au moins une partie du gaz.

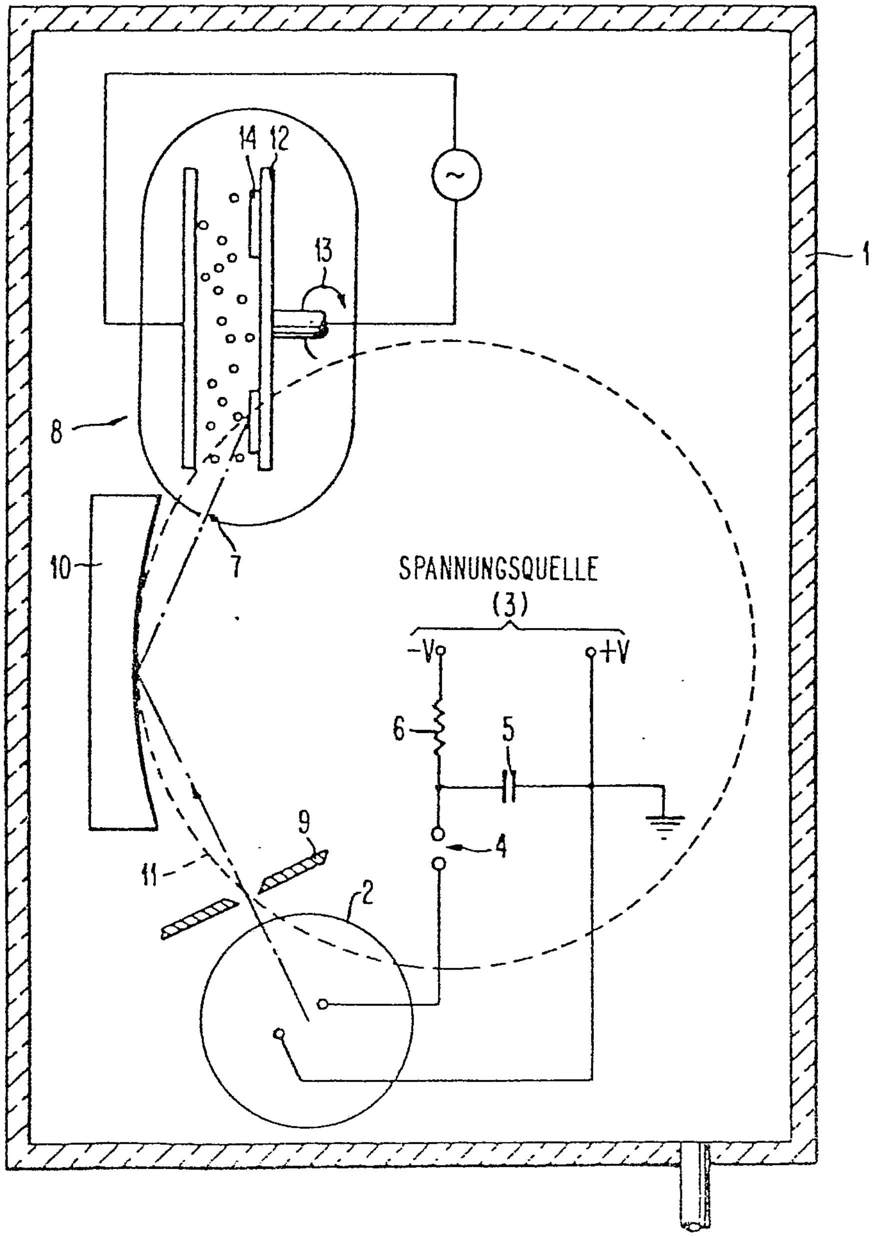


FIG. 1

FIG. 2

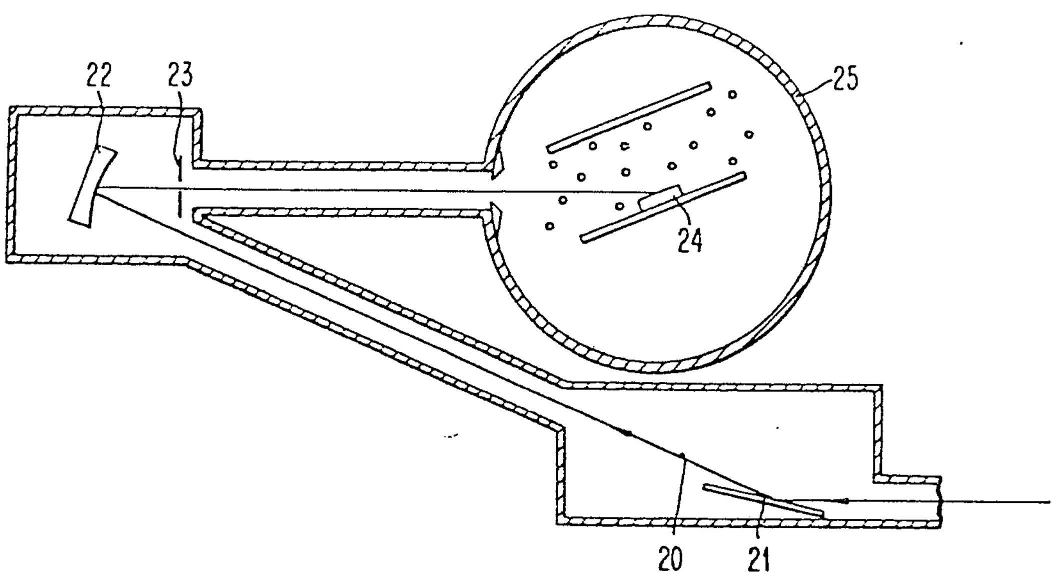


FIG. 3